# FASCICULE DE BREVET EUROPEEN

(11) **EP 0 551 030 B1**
(45) Date de publication et mention de la délivrance du brevet: **15.02.1995**
(21) Numéro de dépôt: 92403241.0
(22) Date de dépôt: 01.12.1992
(51) Int. Cl.: H01L 29/76

(54) **Transistor à puits quantique à effet tunnel résonnant**
Quantentopf-Transistor mit resonantem Tunneleffekt
Quantum well transistor with resonant tunneling effect

(30) Priorité: 10.12.1991 FR 9115270
(43) Date de publication de la demande: 14.07.1993
(73) Titulaire: THOMSON-CSF, 75008 Paris (FR)
(72) Inventeur: Lippens, Didier, THOMSON-CSF, SCPI, F-92402 Courbevoie Cedex (FR); Vinter, Borge, THOMSON-CSF, SCPI, F-92402 Courbevoie Cedex (FR)
(74) Mandataire: Taboureau, James

(56) Documents cités:
- EP-A- 0 253 174
- PHYSICAL REVIEW LETTERS vol. 60, no. 6, 8 Février 1988, NEW YORK USA pages 535 - 537, M.A. REED ET AL. 'Observation of Discrete Electronic States in a Zero-Dimensional Semiconductor Nanostructure'
- PHYSICAL REVIEW LETTERS vol. 66, no. 8, 25 Février 1991, NEW YORK, USA, pages 1082 - 1085, A. GROSHEV ET AL. 'Charging Effects of a Single Quantum Level in a Box'

## Description

La présente invention concerne un transistor à puits quantique, à effet tunnel résonnant, ayant un faible courant de base et un gain élevé dans le domaine des hyperfréquences (plusieurs dizaines de gigahertz).

Dans un dispositif semiconducteur, un puits quantique est formé par une structure à double barrière, ou double hétérojonction - donc interne au corps du dispositif -, dans laquelle la couche du puits est très fine, 1 à 20 nm, et à petite bande interdite, et les deux couches barrières sont à large bande interdite. Les porteurs de charges, les électrons de conduction par exemple, voient une énergie potentielle en forme de puits. L'état énergétique le plus favorable est celui où les électrons sont dans le puits. L'épaisseur de la couche du puits lui-même est suffisamment fine pour qu'apparaissent des phénomènes quantiques, d'où l'appellation "puits quantique".

Il est établi que le filtrage d'un flux d'électrons par des structures à puits quantiques entre deux contacts ohmiques conduit à des caractéristiques courant-tension fortement non-linéaires. L'exemple le plus spectaculaire est celui de la diode double barrière à effet tunnel résonnant qui présente une résistance différentielle négative à température ambiante. Disposer d'un élément actif non linéaire à faible temps de réponse est intéressant pour les applications analogiques hyperfréquences et pour les applications logiques multi états ultra rapides.

Alors que les effets d'interférences constructives à la base des effets résonnants peuvent être mis en application par une simple diode, une troisième électrode de commande est un élément favorable pour le développement des applications. Il apparaît préférable que la commande soit faite directement dans le puits : dans ce cas on peut espérer réaliser un composant où les phénomènes physiques sont quasi instantanés et qui présente une très grande sensibilité en tension.

Plusieurs types de transistors à puits quantiques sont connus, dont certains comportent une injection de porteurs par effet tunnel résonnant. Dans ces transistors, la couche de matériau semiconducteur qui constitue le puits quantique n'est pas limitée latéralement, c'est à dire dans le plan de croissance du matériau, et cette couche s'étend sous les métallisations latérales de base, si la structure est verticale. Les porteurs de charges, injectés par effet tunnel depuis l'émetteur à travers la première barrière et la base, sont collectés seulement si leur énergie est suffisante pour franchir la seconde barrière du puits quantique au niveau du collecteur : les autres porteurs de charges se thermalisent dans la base, et perdent de l'énergie.

Ainsi, tandis que certains électrons énergétiques peuvent traverser la barrière vers le collecteur, d'autres électrons moins énergétiques restent dans le puits puisqu'ils ne peuvent pas franchir la deuxième barrière et s'écoulent latéralement vers la métallisation de base, augmentant le courant de base et diminuant le gain du transistor.

D'autre part M.A. Reed et al. divulguent dans Physical Review Letters, vol. 60, no. 6 (1988), pages 535-537 une diode à puits quantique à effet tunnel résonnant en utilisant une colonne à puits quantique dont l'étranglement latéral est obtenu par un effet de déplétion.

L'invention consiste à empêcher que, dans un transistor à effet tunnel résonnant, des électrons ne puissent changer de niveau d'énergie dans la base, en vue de disposer d'un transistor à faible courant de base, grand gain et fréquence de coupure élevée. Cet objectif est atteint en limitant les dimensions latérales des couches de matériaux semiconducteurs constituant le puits quantique de façon à y introduire les phénomènes de quantification latérale, qui existent déjà perpendiculairement au plan de croissance des dites couches. Il apparaît alors que les niveaux d'énergie, connus sous le nom de sous-bandes, se subdivisent par quantification en états discrets : les relaxations entre états discrets sont moins faciles que les relaxations inter-sous-bandes, parce qu'un électron ne peut relaxer en émettant un phonon que si l'énergie de ce phonon est égale à l'énergie entre deux états. Si les électrons ne peuvent plus relaxer dans le puits quantique, leur énergie devient suffisante pour franchir la seconde barrière du puits, vers le collecteur, ce qui diminue le courant de base et augmente le gain du transistor.

La diminution des dimensions latérales du puits quantique n'est pas une simple mesure géométrique allant dans le sens de la densification des circuits intégrés. C'est une mesure physique qui entraîne l'émergence de phénomènes quantiques et enferme une partie des couches du puits quantique dans une boite quantique, dans laquelle le mouvement des porteurs dans les trois dimensions - et non plus seulement dans la direction selon l'épaisseur du puits- est quantifié.

De façon plus précise, l'invention concerne un transistor à puits quantique à effet tunnel résonnant selon la revendication 1.

L'invention sera mieux comprise par la description plus détaillée qui suit maintenant d'un exemple d'application en liaison avec les figures jointes en annexe, qui représentent :
- figure 1 : coupe simplifiée d'un transistor à tunnel résonnant, selon l'art connu,
- figure 2 : diagramme des bandes d'énergie d'un puits quantique,
- figure 3 : diagramme des états d'énergie en fonction du mouvement parallèle dans un puits quantique.
- figure 4 : coupe simplifiée d'un transistor à boîte quantique, selon l'invention.

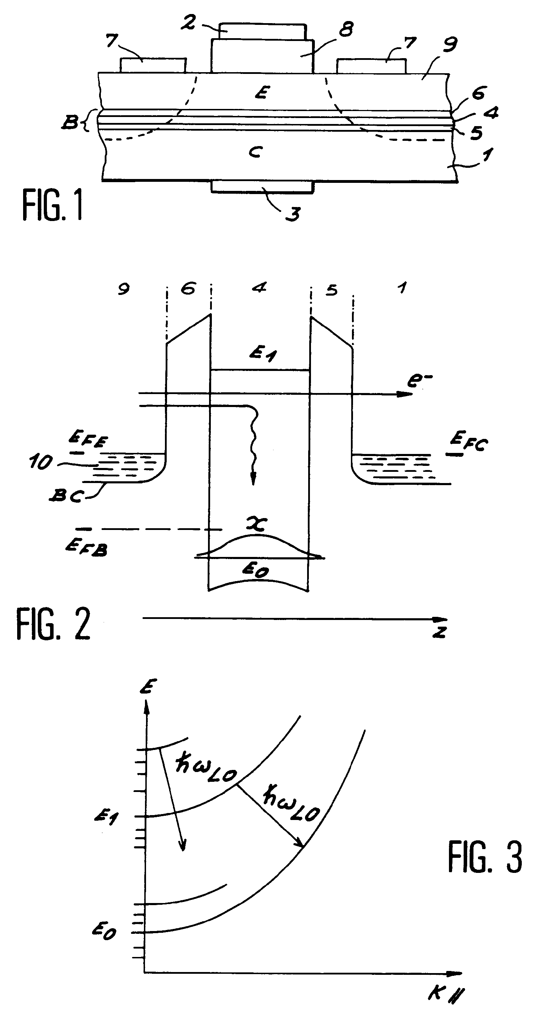

La figure 1 constitue un rappel succint de la structure d'un transistor à puits quantique, qui facilitera la compréhension ultérieure de l'invention. En raison des dimensions du puits quantique, cette structure est obligatoirement verticale, et les épaisseurs sont réglées par les temps de croissance des couches de matériaux semiconducteurs.

Dans un transistor à puits quantique, supporté par un substrat 1, le passage du courant depuis une électrode 2 d'émetteur (en source) vers une électrode 3 de collecteur (ou drain) est contrôlé par un ensemble de fines couches 4+5+6, qui constituent le puits quantique, lui-même contrôlé par l'électrode 7 de base (ou grille), généralement déposée autour d'un mésa 8 qui supporte la métallisation 2 d'émetteur. Une région 9 sépare le puits quantique des métallisations 2 et 7. Bien entendu, les couches 1,9 et 8 peuvent elles-mêmes comporter des sous-couches à gradient de dopage, de lissage, de prises de contacts... etc, qui ne sont pas représentées parce qu'elles ne sont pas nécessaires à la compréhension.

Selon l'art connu, le puits quantique 4 + 5+ 6 n'est pas limité latéralement, dans le plan des couches, c'est à dire qu'en fonction de l'état de l'art en masquage, un puits quantique connu à des dimensions latérales utiles au moins égales à 1 ou 2 micromètres, ce qui est beaucoup.

Les matériaux de ce transistor sont préférablement des matériaux du groupe III - V, tels que GaAs, AlGa As, InP... etc, et la couche centrale 4 du puits a une bande interdite plus faible que celle des couches barrières 5 et 6, et dans quelques propositions de l'art connu plus faible aussi que celle des régions d'émetteur 8 + 9 et de collecteur 1, qui sont à large bande interdite.

Lorsqu'une dimension au moins dans une structure devient inférieure à la longueur d'onde de de Broglie, des phénomènes quantiques apparaissent. Dans un puits quantique, en raison de la faible bande interdite de la couche 4, d'épaisseur inférieure à 20 nm, les électrons voient une énergie potentielle en forme de puits, et leur état énergétique le plus favorable est celui où ils sont dans le puits. Comme la fonction d'onde ne peut pénétrer que faiblement dans les matériaux barrière 5 et 6 - grâce à l'effet tunnel de la mécanique quantique - on peut en première approximation considérer que la fonction d'onde des électrons s'annule aux deux interfaces du puits. Les fonctions d'ondes solutions de l'équation de Schrödinger, pour le mouvement perpendiculaire aux couches, sont alors discrètes, quantifiées. Et comme l'énergie des niveaux d'électrons est liée aux dites fonctions d'ondes, l'énergie correspondant au mouvement dans la direction de croissance, perpendiculaire aux couches, est aussi quantifiée.

Le mouvement des électrons parallèlement aux couches -c'est à dire latéralement dans le transistor- n'est pas affecté par cette quantification. C'est un mouvement de particules libres à deux degrés de liberté, en bidimensionnel.

Ceci se comprend mieux en se reportant à la figure 2, qui donne la structure de bande de conduction d'un transistor à effet tunnel résonnant à puits quantique enterré. Pour matérialiser les couches de matériaux du dispositif, on a reporté sur le diagramme les indices de repères de la figure 1. L'axe z indique l'axe de croissance des couches.

Les deux barrières 5 et 6 sont constituées par un matériau semiconducteur à large bande interdite - par exemple AlGaAs- par rapport au matériau des régions d'émetteur et collecteur 9 et 1 - par exemple GaAs -. Le matériau du puits 4 - par exemple InGaAs- possède une bande interdite plus faible que celles des autres matériaux. Le puits est suffisamment profond et large - 5 à 20 nm selon l'axe z- pour que le niveau fondamental Eₒ d'énergie soit sous la bande de conduction BC de l'émetteur.

Par le choix de la largeur du puits, il est possible de localiser strictement des électrons sur le niveau fondamental Eₒ, dans un état dit lié.

Au moyen d'un contact ohmique sur la base, qui constitue un réservoir d'électrons, il est possible de faire varier la densité de surface de charges nₛ piégées dans le puits. En effet, sous l'action de la tension V_{BE} entre base et émetteur, on modifie l'écart entre les niveaux de Fermi E_{FE} dans l'émetteur et E_{FB} dans la base. Dans la mesure où une charge piégée au niveau fondamental E_{O} est directement liée à la différence E_{FB} - Eₒ, on module par V_{BE} de la densité de surface nₛ, ce qui se répercute sur la courbure de bande dans le puits et donc sur la position du niveau excité E₁, assurant la conduction, par rapport aux états peuplés d'émetteur, situés - en 10- en première approximation sous le niveau de Fermi E_{FE} de l'émetteur. La variation relative entre E_{FE} fixe et E₁ qui a varié de niveau permet de moduler le courant tunnel entre émetteur et collecteur, symbolisé sur la figure 2 par un électron e⁻ qui traverse les deux barrières 5 et 6.

Dans les faits, une fraction non négligeable de porteurs injectés dans le puits relaxent vers le niveau fondamental E₀ en un temps très court. Ils se trouvent donc piégés au niveau fondamental Eₒ, perturbant le fonctionnement du transistor car le courant émetteur-base qui en résulte diminue le gain du transistor. Il est connu que c'est un désavantage des transistors à hétérostructure que d'avoir de mauvaises performances à température ambiante : comme les hauteur de barrière Δ E_{c} sont faibles (300 meV) en comparaison des barrières de Schottky (600-800 meV), ou des interfaces MOS (3eV) ou encore des hauteurs de bandes interdites dans le silicium ou GaAs, il s'ensuit que les courants de fuite sont très importants.

Les temps de relaxation entre les deux niveaux excité E₁ et fondamental Eₒ sont tout à fait comparables aux temps de durée de vie par effet tunnel de l'état quasi-lié E₁. La relative facilité avec laquelle les porteurs relaxent de E₁ vers Eₒ peut se comprendre en considérant la figure 3, qui donne les états d'énergie E en fonction du mouvement K des électrons parallèlement aux surfaces du puits quantique - c'est à dire latéralement, pour un transistor -.

Pour un puits quantique de potentiel infini, constitué de couches non limitées en surface, le mouvement libre des électrons dans les deux directions parallèles aux barrières crée un continuum d'états des sous-bandes d'énergie : un électron peut facilement émettre un phonon optique d'énergie ℏωₗₒ (ℏ = constante de Planck/2¶, ω = vitesse angulaire) pour transférer vers les états de basses énergies, et relaxer du niveau quasi-lié de la bande E₁ vers le niveau lié de la bande Eₒ. Cette relaxation est possible parce que, le puits n'étant pas quantifié dans les deux directions parallèles aux barrières, il n'existe que des bandes d'énergie telles que Eₒ et E₁, et l'énergie d'un phonon correspond à celle entre deux bandes.

Il n'en est plus de même pour un transistor à boite quantique selon l'invention, dans lequel les couches du puits quantique sont limitées, latéralement, à des dimensions plus petites que la longueur d'onde de de Broglie. La perte des degrés de liberté dans les directions autres que la direction de croissance des couches se traduit par une quantification en états discrets dans le sens latéral, avec émergence de niveaux discrets d'énergie. Si l'espacement entre deux niveaux est différent de l'énergie d'un phonon, il est possible d'observer des transitions entre ces deux niveaux : il y a donc moins d'électrons piégés dans le puits, le courant de base est moindre et le gain est supérieur.

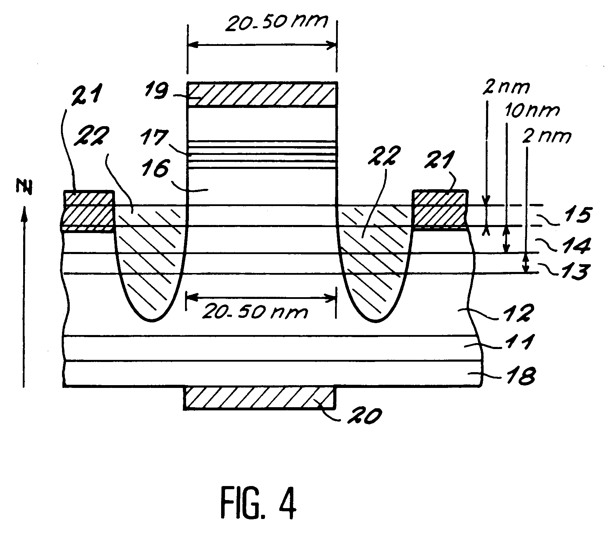

La figure 4 représente une coupe d'un transistor à boîte quantique selon l'invention. Ce transistor comprend, supportées par un substrat 11 en matériau III-V dopé tel que GaAs, une pluralité de couches dont la croissance (direction z) est soigneusement contrôlée :
- espaceur 12, d'épaisseur 30 à 50 nm, en GaAs non dopé ou peu dopé de type n,
- première barrière 13, d'épaisseur 2 nm, en AlₓGa₁₋ₓAs non dopé,
- puits quantique 14 d'épaisseur 10 nm, en Ga_{y} In _{1-y} As non dopé, avec y = 0,85,
- deuxième barrière 15 identique à la première barrière,
- espaceur 16 identique à l'espaceur 12,
- mésa d'émetteur 17 en GaAs dopé n+, éventuellement par dopage planaire par implantation d'ions Si en cours de croissance.
- contact collecteur 18, en GaAs dopé n⁺ sur la face arrière du substrat 11.

Par des techniques connues qu'il n'est pas utile du détailler, une mésa est gravée dans les couches 16 et 17 de contact émetteur , et cette mésa a entre 20 et 50 nm de dimension latérale, parallèlement aux plans des couches. Sur cette mésa est déposée une métallisation 19 d'émetteur, et sur le contact collecteur 18 est déposée une métallisation 20 de collecteur. Au pied de la mésa est déposée une métallisation 21 de base, non alliée et peu profonde pour ne pas court-circuiter le puits quantique 14 : le contact de base 21 est à une distance de la mésa 16 + 17 de l'ordre de l'épaisseur des couches 13+14+15, soit dans l'exemple choisi 14 nm. Le confinement latéral des électrons dans la couche 14 entre les deux barrières 13 et 15 est obtenu par le potentiel de la surface libre entre la mésa et contact 21.

Lorsque des tensions sont appliquées sur les métallisations 19 et 21, il se crée au pied de la mésa une zône 22 de désertion, qui enferme une partie du puits quantique 14 dans une "boite quantique" dont les dimensions latérales, parallèlement aux plans des couches,sont inférieures à la longueur donde de de Broglie.

Concrétement, l'espacement entre les niveaux d'énergie Eₒ et E₁ dépend des dimensions latérales de la boite, c'est à dire de l'ouverture du potentiel qui confine latéralement les électrons : cette ouverture est de l'ordre de 20 nm pour une énergie de phonon de 36 meV. Avec des barrières en AlGa As d'épaisseur de 1,7 nm et un puits en Ga_{1-y}In_{y} As (y= 0,85) haut de 10 nm, on obtient un abaissement de 150 meV du fond du puits par rapport au bas de la bande de conduction : pour un puits de 10 nm de hauteur, cet offset est suffisant pour localiser strictement le niveau fondamental Eₒ et rendre impossible les transitions entre E₁ et E₀ car l'espacement entre ces deux niveaux est supérieur à ℏωₗₒ.

Les faibles dimensions d'un transistor selon l'invention imposent que sa structure soit verticale : c'est le seul moyen envisageable pour avoir des distances telles que 1,7 nm bien précises. Mais cela implique que le contact de base 21, ohmique, qui est déposé directement sur la barrière 15 du puits quantique soit peu diffusé, pour ne pas mettre en court-circuit les couches de base et de collecteur.

Conformément au principe de fonctionnement exposé précédemment, l'effet transistor est obtenu en modulant la charges d'espace piégée dans le puits, ce qui entraîne par réaction de la charge d'espace une modification de position du niveau E₁.

Le transistor à puits quantique selon l'invention est appliqué à l'électronique rapide, puisque ses fréquences de travail peuvent atteindre 200 GHz.

## Revendications

1. Transistor à puits quantique à effet tunnel résonnant, comportant au moins un puits quantique (14), comprenant une couche de matériau semiconducteur de faible bande interdite, compris entre deux barrières (13,15) constituées par deux couches de matériau semiconducteur à large bande interdite, les dites couches (13,14,15) étant d'épaisseurs faibles de sorte qu'intervient une quantification selon l'axe (z) de croissance des couches (13,14,15), et étant en outre situées entre un substrat (11) qui porte une couche de collecteur (18) et une métallisation de collecteur (20) et un mésa (16,17,19) qui comprend une couche d'émetteur et une métallisation d'émetteur (19), le puits quantique (14) étant délimité latéralement, selon les plans des dites couches, par une zone de désertion (22) qui forme une boite quantique dont les dimensions latérales sont inférieures à la longueur d'onde de de Broglie, la dite zone de désertion (22) étant créée, au pied de la mésa (16,17,19) d'émetteur par une tension de polarisation appliquée sur une métallisation de base (21) déposée sur une couche barrière (15), autour du pied de la mésa (16,17,19).

2. Transistor selon la revendication 1, caractérisé en ce que les couches d'émetteur (17) et de collecteur (18) sont en GaAs, les barrières (13,15) en Alₓ Ga₁₋ₓAs (0<x<1) et le puits (14) en Ga_{1-y}In_{y} As (0<y<1).

3. Transistor selon la revendication 1, caractérisé en ce que le matériau semiconducteur du puits (14) a une hauteur de bande interdite plus faible que celle des matériaux des couches d'émetteur (17) et de collecteur (18).

4. Transistor selon la revendication 1, caractérisé en ce que les épaisseurs des couches, selon l'axe (z) de croissance sont de l'ordre de 10 nm pour le puits (14) , 2 nm pour les barrières (13,15) et en ce que les dimensions latérales de la boite quantique sont comprises entre 20 et 50 nm.

## Patentansprüche

1. Quantentopf-Transistor mit resonantem Tunneleffekt, der wenigstens einen Quantentopf (14) enthält, mit einer Schicht aus Halbleitermaterial mit schmalem verbotenem Band, welche Schicht zwischen zwei Barrieren (13, 15) enthalten ist, die durch zwei Schichten aus Halbleitermaterial mit breitem verbotenem Band gebildet sind, wobei die Schichten (13, 14, 15) geringe Dicken aufweisen, derart, daß eine Quantisierung entlang der Achse (z) des Wachstums der Schichten (13, 14, 15) auftritt, und überdies zwischen einem Substrat (11), das eine Kollektorschicht (18) trägt, und einer Kollektormetallisierung (20) sowie einem Mesa (16, 17, 19) angeordnet sind, der eine Emitterschicht und eine Emittermetallisierung (19) enthält, wobei der Quantentopf (14) entlang der Ebenen der Schichten seitlich durch eine Abfallzone (22) begrenzt ist, die einen Quantenbehälter bildet, dessen Seitenabmessungen kleiner als die De-Broglie-Wellenlänge sind, und wobei die Abfallzone (22) am Fuß des Emitter-Mesa (16, 17, 19) durch eine Polarisationsspannung, die an eine auf eine Barrierenschicht (15) aufgebrachte Basismetallisierung (21) angelegt ist, um den Fuß des Mesa (16, 17, 19) erzeugt wird.

2. Transistor nach Anspruch 1, dadurch gekennzeichnet, daß die Emitter- und Kollektorschichten (17 bzw. 18) aus GaAs, die Barrieren (13, 15) aus Alₓ Ga₁₋ₓ As (0 < x < 1) und der Topf (14) aus Ga_{1-y} In_{y} As (0 < y 1) bestehen.

3. Transistor nach Anspruch 1, dadurch gekennzeichnet, daß das Halbleitermaterial des Topfes (14) eine Höhe des verbotenen Bandes besitzt, die geringer als die der Materialien der Emitter- und Kollektorschichten (17 bzw. 18) ist.

4. Transistor nach Anspruch 1, dadurch gekennzeichnet, daß die Dicken der Schichten entlang der Wachstumsachse (z) in der Größenordnung von 10 nm für den Topf (14) und in der Größenordnung von 2 nm für die Barrieren (13, 15) liegen und daß die Seitenabmessungen des Quantenbehälters zwischen 20 und 50 nm liegen.

## Claims

1. Resonant-tunnel-effect quantum-well transistor, including at least one quantum well (14), comprising a layer of semiconductor material with low forbidden band, lying between two barriers (13, 15) consisting of two layers of semiconductor material with high forbidden band, the said layers (13, 14, 15) being of shallow thickness so that quantization occurs along the axis (z) of growth of the layers (13, 14, 15), and being situated moreover between a substrate (11) which carries a collector layer (18) and a collector metallization (20) and a mesa (16, 17, 19) which comprises an emitter layer and an emitter metallization (19), the quantum well being delimited laterally, along the planes of the said layers, by a depletion region (22) which forms a quantum box the lateral dimensions of which are smaller than the de Broglie wavelength, the said depletion region (22) being created, at the foot of the emitter mesa (16, 17, 19) by a bias voltage applied to a base metallization (21) deposited on a barrier layer (15), around the foot of the mesa (16, 17, 19).

2. Transistor according to Claim 1, characterized in that the emitter (17) and collector (18) layers are of GaAs, the barriers (13, 15) of Alₓ Ga₁₋ₓAs (0<x<1) and the well (14) of Ga_{1-y}In_{y} As (0<y<1).

3. Transistor according to Claim 1, characterized in that the semiconductor material of the well (14) has a forbidden band height which is lower than that of the materials of the emitter (17) and collector (18) layers.

4. Transistor according to Claim 1, characterized in that the thickness of the layers, along the growth axis (z) are of the order of 10 nm for the well (14), 2 nm for the barriers (13, 15), and in that the lateral dimensions of the quantum box lie between 20 and 50 nm.
